# EUROPEAN PATENT APPLICATION

(11) **EP 4 711 772 A1**
(43) Date of publication of application: **18.03.2026**
(21) Application number: 24803267.4
(22) Date of filing: 05.03.2024
(51) Int. Cl.: G01R 1/06, G01R 1/073, H01L 21/66

(54) **PROBE AND ELECTRICAL CONNECTION DEVICE**

(30) Priority: 09.05.2023 JP 2023077287
(71) Applicant: Kabushiki Kaisha Nihon Micronics, Musashino-shi Tokyo 180-8508 (JP)
(72) Inventor: NASU Mika, Musashino-shi, Tokyo 180-8508 (JP); HAYASHIZAKI Takayuki, Musashino-shi, Tokyo 180-8508 (JP)
(74) Representative: Samson & Partner Patentanwälte mbB
(86) International application number: PCT/JP2024/008308
(87) International publication number: WO 2024/232152

(57) **Abstract**

A probe includes: a tip member including a contact portion and a base end portion connected to the contact portion; a main body in which the base end portion is embedded in an end portion; and a first reinforcing member arranged on a side surface of the main body so as to overlap with at least a part of the base end portion. The base end portion is embedded in the end portion of the main body so as to expose the contact portion. The first reinforcing member is continuously arranged on a side surface of the main body from an embedded region in which the base end portion is embedded to a region around the embedded region.

## Description

### TECHNICAL FIELD

The present invention relates to a probe and an electrical connection device, used for inspecting electrical characteristics of an inspection object.

### BACKGROUND ART

An electrical connection device including a probe has been used so as to inspect electrical characteristics of an inspection object, such as a semiconductor integrated circuit, in a wafer state. In the inspection using a probe, one end portion of the probe is brought into contact with an electrode of the inspection object, and the other end portion of the probe is brought into contact with a terminal (hereinafter referred to as "land") arranged on a printed substrate or the like. The land is electrically connected to an inspection device such as a multimeter.

### CITATION LIST

### Patent Literature

Patent Literature 1: JP 2015-118064 A

### SUMMARY OF INVENTION

### Problems To Be Solved By Invention

In order to suppress abrasion of an end portion of a probe due to contact with an inspection object or a land, a probe in which a tip member made of a hard material with a higher hardness than that of a main body is embedded in the end portion of the main body has been used. An object of the present invention is to provide a probe and an electrical connection device, that suppress detachment of a tip member from a main body of the probe, the tip member embedded in an end portion of the main body.

### Solution To Solve Problems

A probe according to an aspect of the present invention includes: a tip member including a contact portion and a base end portion connected to the contact portion; a main body in which the base end portion is embedded in an end portion; and a reinforcing member arranged on a side surface of the main body so as to overlap with at least a part of the base end portion. The base end portion is embedded in the end portion of the main body so as to expose the contact portion. The reinforcing member is continuously arranged on a side surface of the main body from an embedded region in which the base end portion is embedded to a region around the embedded region.

### Effects of Invention

The present invention can provide a probe and an electrical connection device, that suppress detachment of a tip member from a main body of the probe, the tip member embedded in an end portion of the main body,.

### BRIEF DESCRIPTION OF DRAWINGS

[FIG. 1] FIG. 1 is a schematic plan view of a first side surface illustrating a configuration of a probe according to an embodiment of the present invention.
[FIG. 2] FIG. 2 is a schematic plan view of a second side surface illustrating the configuration of the probe according to the embodiment of the present invention.
[FIG. 3] FIG. 3 is a schematic cross-sectional view taken along the III-III direction of FIGS. 1 and 2.
[FIG. 4] FIG. 4 is a schematic perspective view illustrating a configuration of a first reinforcing member of the probe according to the embodiment of the present invention.
[FIG. 5] FIG. 5 is a schematic perspective view illustrating a configuration of a second reinforcing member of the probe according to the embodiment of the present invention.
[FIG. 6] FIG. 6 is a schematic perspective view illustrating an embedded region, with a main body and the second reinforcing member of the probe according to the embodiment of the present invention, illustrated in a transparent manner.
[FIG. 7] FIG. 7 is a schematic cross-sectional view illustrating an example of an arrangement of the reinforcing member in the probe according to the embodiment of the present invention.
[FIG. 8] FIG. 8 is a schematic cross-sectional view illustrating another example of the arrangement of the reinforcing member in the probe according to the embodiment of the present invention.
[FIG. 9] FIG. 9 is a schematic cross-sectional view illustrating yet another example of the arrangement of the reinforcing member in the probe according to the embodiment of the present invention.
[FIG. 10] FIG. 10 is a schematic view illustrating a configuration of an electrical connection device according to the embodiment of the present invention.
[FIG. 11] FIG. 11 is a schematic view illustrating a state of the electrical connection device according to the embodiment of the present invention, during inspection.
[FIG. 12] FIG. 12 is a schematic plan view of a first side surface illustrating a configuration of a probe according to a modified example of the embodiment of the present invention.
[FIG. 13] FIG. 13 is a schematic plan view of a second side surface illustrating the configuration of the probe according to a modified example of the embodiment of the present invention.

### DESCRIPTION OF EMBODIMENT

Next, an embodiment of the present invention will be described with reference to the drawings. In the following description of the drawings, identical or similar parts are denoted by identical or similar reference numerals. However, it should be noted that the drawings are schematic, and the thickness ratios of each part differ from actual ones. It is also natural that portions with different dimensional relationships and ratios are included between the drawings. The embodiment shown below exemplifies devices and methods for embodying the technical concept of the present disclosure, and the embodiments do not limit the materials, shapes, structures, arrangements, manufacturing methods and the like of the component parts to those described below.

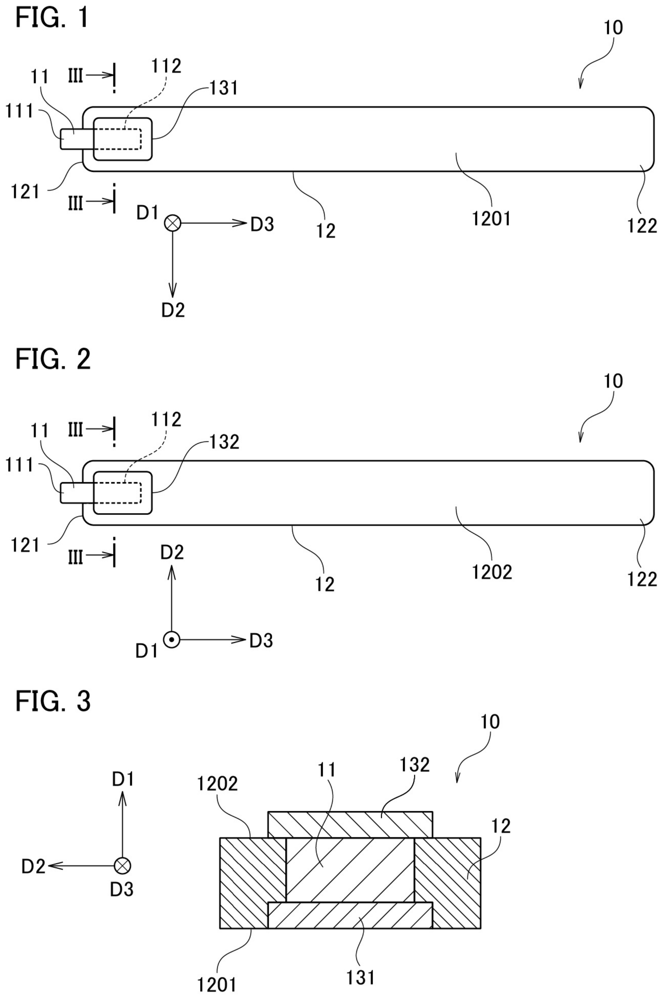

A probe 10 according to an embodiment illustrated in FIG. 1 is used for inspecting the electrical characteristics of an inspection object. The probe 10 includes a tip member 11 that has a contact portion 111 and a base end portion 112 connected to the contact portion 111, a main body 12 in which the base end portion 112 is embedded, and a first reinforcing member 131 that is arranged on a first side surface 1201 of the main body 12 so as to overlap with at least a part of the base end portion 112. The base end portion 112 of the tip member 11 is embedded in the first end portion 121 of the main body 12 so as to expose the contact portion 111.

The probe 10 has a columnar shape extending linearly from the first end portion 121 to the second end portion 122 in a third direction D3. The third direction D3 corresponds to an axial direction of the probe 10. FIG. 1 is a plan view of the first side surface 1201 of the main body 12 as viewed from a plane normal direction. The direction parallel to the plane normal direction of the first side surface 1201 is designated as a first direction D1. The direction perpendicular to both the first direction D1 and the third direction D3 is designated as a second direction D2. The second direction D2 corresponds to the width direction of the probe 10.

For example, in the inspection of an inspection object, the tip member 11 embedded in the first end portion 121 may come into contact with the inspection object, and the second end portion 122 of the main body 12 may come into contact with the land. Alternatively, the tip member 11 embedded in the first end portion 121 may come into contact with the land, and the second end portion 122 of the main body 12 may come into contact with the inspection object.

FIG. 2 illustrates a plan view of a second side surface 1202 of the main body 12 as viewed from the plane normal direction. As illustrated in FIG. 2, the probe 10 includes a second reinforcing member 132 that is arranged on the second side surface 1202 of the main body 12 so as to overlap with at least a part of a base end portion 112. As illustrated in FIG. 3, the main body 12 has a rectangular cross-sectional shape perpendicular to the axial direction, and the first side surface 1201 and the second side surface 1202 face each other.

As illustrated in FIGS. 1 and 3, the first reinforcing member 131 is embedded in the first side surface 1201 of the main body 12 and overlaps with the base end portion 112. Therefore, as illustrated in FIG. 3, the first side surface 1201 of the main body 12 around the region in which the base end portion 112 of the main body 12 is embedded (hereinafter, it is also referred to as "embedded region") and the surface of the first reinforcing member 131 are continuous without any step. As illustrated in FIGS. 2 and 3, the second reinforcing member 132 is arranged on the surface of the second side surface 1202 of the main body 12 and overlaps with the base end portion 112. In the second side surface 1202, as illustrated in FIG. 3, a step is generated at the boundary between the surface of the second side surface 1202 of the main body 12 around the embedded region and the surface of the second reinforcing member 132.

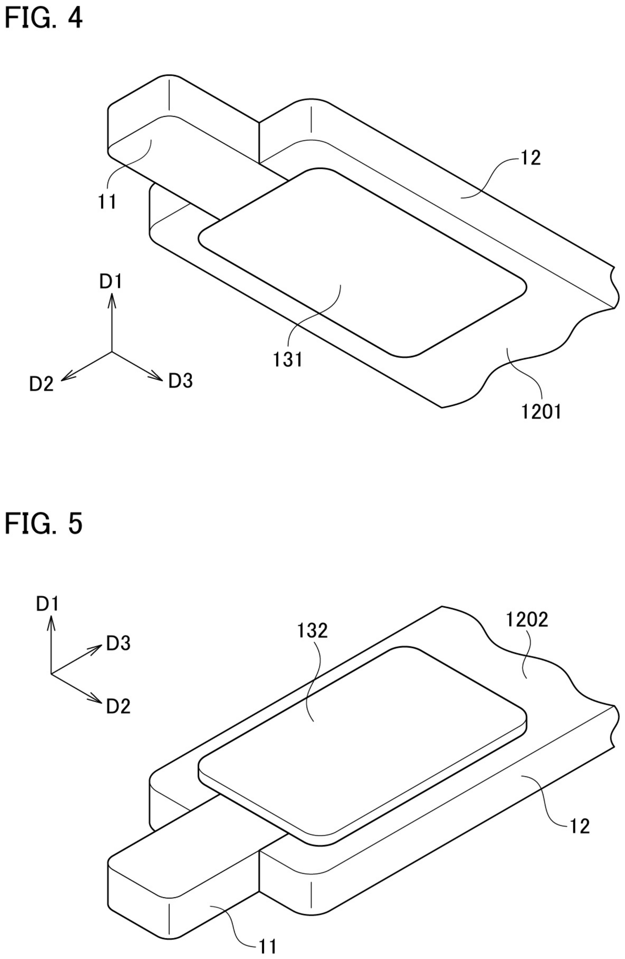

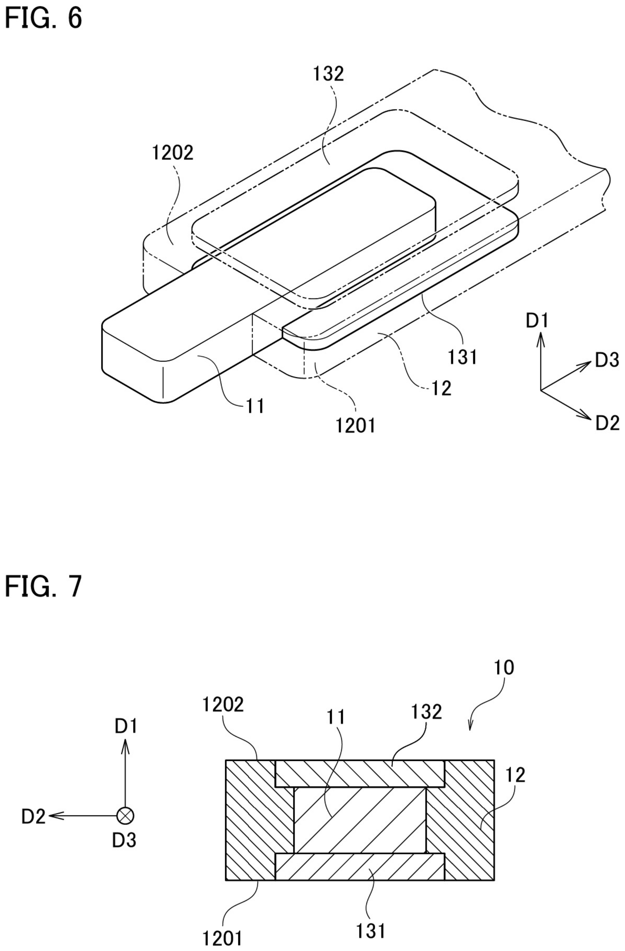

FIG. 4 is a perspective view illustrating the configuration of the first reinforcing member 131 arranged on the first side surface 1201 of the main body 12. The first reinforcing member 131 is embedded in the first side surface 1201. FIG. 5 is a perspective view illustrating the configuration of the second reinforcing member 132 arranged on the second side surface 1202 of the main body 12. The second reinforcing member 132 is arranged on the surface of the second side surface 1202. FIG. 6 is a perspective view corresponding to FIG. 5, which illustrates the embedded region with the main body 12 and the second reinforcing member 132 illustrated in a transparent manner.

Hereinafter, when the first reinforcing member 131 and the second reinforcing member 132 are not specifically distinguished, they are referred to as a "reinforcing member 13". Moreover, when the first side surface 1201 and the second side surface 1202 are not specifically distinguished, they are referred to as a "side surface 120".

According to the probe 10, the reinforcing member 13 is arranged on the side surface 120 of the main body 12 so as to overlap with at least a part of the base end portion 112 of the tip member 11, thereby preventing the tip member 11 from detaching from the main body 12. For example, repeated inspection reduces the joining strength between the tip member 11 in contact with the electrode of the inspection object and the main body 12. The reinforcing member 13 is arranged on the side surface 120 of the main body 12 so as to overlap with the base end portion 112, thereby preventing the tip member 11 from detaching from the main body 12. In order to enhance the effect of preventing the tip member 11 from detaching from the main body 12 (hereinafter, it is also referred to as "reinforcing effect"), the reinforcing member 13 is continuously arranged on the side surface 120 of the main body 12 from the embedded region to the region around the embedded region. For enhancing the reinforcing effect, it is preferable that the area where the reinforcing member 13 is in contact with the tip member 11 and the main body 12 is larger.

In order to electrically connect the electrode of the inspection object with the land, conductive materials such as metal materials are used for the tip member 11 and the main body 12. Furthermore, the materials of the tip member 11 and the main body 12 may be selected such that the tip member 11 has a higher hardness than the main body 12. By embedding the tip member 11 that has a higher hardness than the main body 12 in the end portion of the main body 12, it is possible to suppress the abrasion of the end portion of the probe 10 due to contact with the inspection object or the land.

The materials of the tip member 11 and the main body 12 may be selected such that the conductive property of the tip member 11 and the main body 12 is the same or the tip member 11 has a higher conductive property than that of the main body 12. By selecting the materials of the tip member 11 and the main body 12 in this way, the electrical resistance of the probe 10 can be reduced. For example, the tip member 11 may be made of rhodium (Rh), platinum (Pt), or other precious metals. The main body 12 may be made of nickel (Ni), nickel alloy, gold (Au), silver (Ag), copper (Cu), palladium (Pd), palladium alloy, rhodium (Rh), rhodium alloy, or other precious metals.

The probe 10 illustrated in FIG. 1 can be manufactured by, for example, the following process. First, the first reinforcing member 131 is formed, and the tip member 11 is formed such that the base end portion 112 overlaps with the first reinforcing member 131. Next, the main body 12 is formed such that the base end portion 112 is embedded in the first end portion 121. Then, the second reinforcing member 132 is formed on the second side surface 1202 of the main body 12 so as to overlap with the base end portion 112.

Any material can be used as the material of the reinforcing member 13. Here, in order to increase the reinforcing effect, it is preferable that the adhesion between the reinforcing member 13, the tip member 11, and the main body 12 is high. Therefore, the same material as the tip member 11 or the main body 12 may be used for the reinforcing member 13. In order to increase the reinforcing effect, it is preferable that the reinforcing member 13 has a high hardness. Accordingly, the reinforcing member 13 and the tip member 11 may be made of the same material.

In addition, as described above, the probe 10 is manufactured by the process of laminating the reinforcing member 13, and the tip member 11 and the main body 12. Therefore, it is preferable to select a material that is hard to oxidize for the reinforcing member 13 such that the joining force between the tip member 11 and the main body 12, and the reinforcing member 13 is not lowered due to oxidation of the surface of the reinforcing member 13, the tip member 11 or the main body 12 during the manufacturing process.

As described above, in the probe 10 according to the embodiment, the reinforcing member 13 is arranged on the side surface 120 of the main body 12 so as to overlap with at least a part of the base end portion 112, thereby acquiring a reinforcing effect that prevents the tip member 11 from detaching from the main body 12. This can solve, for example, the problem of the tip member 11 becoming detached from the main body 12 during inspection of an inspection object.

In the above description, a description has been given of the probe 10 in which the first reinforcing member 131 is embedded in the first side surface 1201 of the main body 12 and the second reinforcing member 132 is arranged on the surface of the second side surface 1202 of the main body 12. However, the configuration in which the reinforcing member 13 is arranged on the side surface 120 of the main body 12 is not limited to the above configuration.

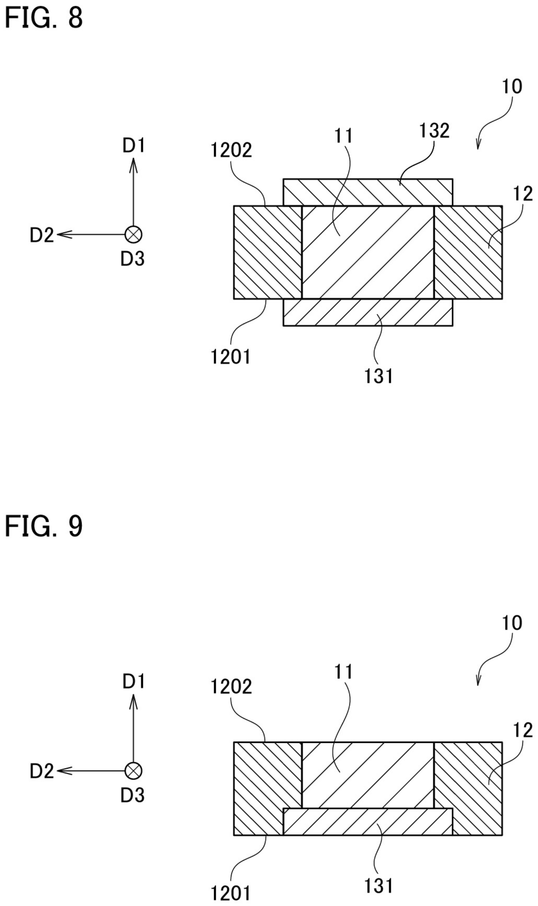

For example, as illustrated in FIG. 7, the first reinforcing member 131 may be embedded in the first side surface 1201 and the second reinforcing member 132 may be embedded in the second side surface 1202. Moreover, as illustrated in FIG. 8, the first reinforcing member 131 may be arranged on the surface of the first side surface 1201 and the second reinforcing member 132 may be arranged on the surface of the second side surface 1202. FIGS. 7 and 8 are cross-sectional views taken along the III-III direction of FIGS. 1 and 2.

As described above, the reinforcing member 13 may be embedded in the side surface 120 or may be arranged on the surface of the side surface 120. Alternatively, a portion of the reinforcing member 13 may be embedded in the side surface 120. For example, the lower portion of the reinforcing member 13 may be embedded in the side surface 120 and the upper portion of the reinforcing member 13 may be exposed on the side surface 120. Alternatively, the region of the reinforcing member 13 embedded in the side surface 120 and the region exposed on the surface of the side surface 120 may be continuous when viewed from the plane normal direction of the side surface 120.

Further, as illustrated in FIG. 9, the first reinforcing member 131 may be arranged on only one side surface 120 of the main body 12. FIG. 9 is a cross-sectional view taken along the III-III direction of FIGS. 1 and 2. Although FIG. 9 illustrates an example in which the reinforcing member 13 is arranged only on the first side surface 1201, it goes without saying that the reinforcing member 13 is arranged only on the second side surface 1202. By adopting the configuration in which the reinforcing member 13 is arranged only on one side surface 120 of the main body 12, the manufacturing process of the probe 10 can be shortened. In contrast, by arranging the reinforcing member 13 on a plurality of side surfaces of the main body 12, the reinforcing effect can be further enhanced.

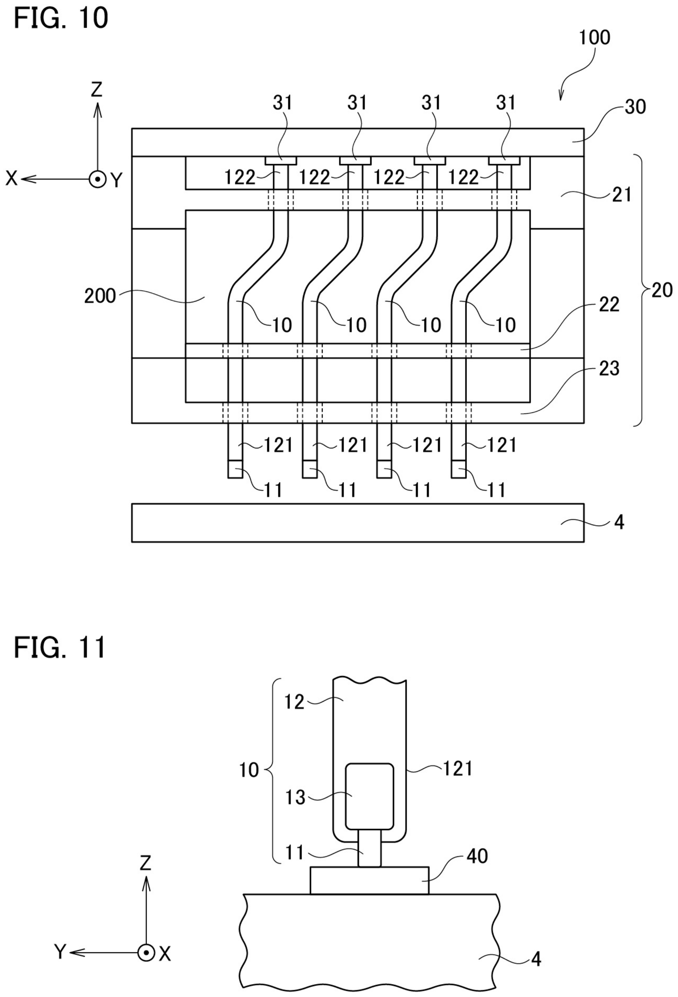

The probe 10 is used, for example, in an electrical connection device 100 illustrated in FIG. 10. In the electrical connection device 100, the probe 10 is held by a probe head 20. Specifically, a plurality of probes 10 are continuously inserted into the respective guide holes of the first guide plate 21, the second guide plate 22, and the third guide plate 23 included in the probe head 20, and are held by the probe head 20. Hereinafter, when the first guide plate 21, the second guide plate 22, and the third guide plate 23 are not specifically distinguished, they are referred to as a guide plate. The probe head 20 has a configuration in which the first guide plate 21, the second guide plate 22, and the third guide plate 23 as a plurality of guide plates are arranged apart from each other in the plane normal direction of the main surface of the guide plate (Z direction).

The tip member 11 is arranged at the first end portion 121 of the probe 10. During the inspection of the inspection object 4, the tip member 11 comes into contact with the electrode 40 arranged on the inspection object 4, for example, as illustrated in FIG. 11. The second end portion 122 of the main body 12 comes into contact with the land 31 of the substrate 30. The land 31 is electrically connected to an inspection device such as an IC tester (not illustrated).

As illustrated in FIG. 10, with respect to the guide holes through which the same probe 10 penetrates, the position of the guide hole of the first guide plate 21 is shifted in the -X direction with respect to the guide hole of the second guide plate 22 in parallel with the main surface of the second guide plate 22. FIG. 10 is a side view as viewed from the Y direction perpendicular to both the X direction and the Z direction. Hereinafter, an arrangement in which the position of the guide hole is shifted is referred to as an "offset arrangement". Further, a direction in which the position of the guide hole is shifted is referred to as an "offset direction". In FIG. 10, the offset direction is the -X direction. Due to the offset arrangement, the main body 12 of the probe 10 is curved in the interior of the probe head 20. That is, in the hollow region 200 between the first guide plate 21 and the second guide plate 22, the main body 12 is curved due to elastic deformation. The position of the guide hole of the second guide plate 22 and the position of the guide hole of the third guide plate 23 coincide with each other when viewed from the Z direction.

Due to the offset arrangement of the guide hole of the first guide plate 21 and the guide hole of the second guide plate 22, when the probe 10 comes into contact with the inspection object 4, the probe 10 buckles in the hollow region 200. That is, in the contact state in which the probe 10 comes into contact with the inspection object 4, the probe 10 is further curved by deflection deformation from the curved shape in the non-contact state in which the probe 10 is not in contact with the inspection object 4. As the probe 10 is further curved, the probe 10 comes into contact with the inspection object 4 at a predetermined pressure. Therefore, due to the offset arrangement, the electrical characteristics of the inspection object 4 can be stably measured using the probe 10. When the probe 10 returns to the non-contact state, it has elasticity to return to the shape before coming into contact with the inspection object 4.

Although the configuration in which the probe head 20 includes three guide plates has been illustrated as an example, the number of guide plates of the probe head 20 may be two or four or more.

In order to increase the adhesion between the reinforcing member 13, and the tip member 11 and the main body 12, it is preferable that the reinforcing member 13 has a large area. For example, the reinforcing member 13 may be arranged over the entire length of the main body 12. Meanwhile, when the probe 10 is held by the probe head 20 in a curved state as illustrated in FIG. 10, the reinforcing member 13 need not be extended to the region where the main body 12 is curved. Since the reinforcing member 13 is not arranged in the region where the main body 12 is curved, it is possible not to prevent the curving of the main body 12, or suppress the peel-off of the reinforcing member 13 in the curved region.

### <Modified Example>

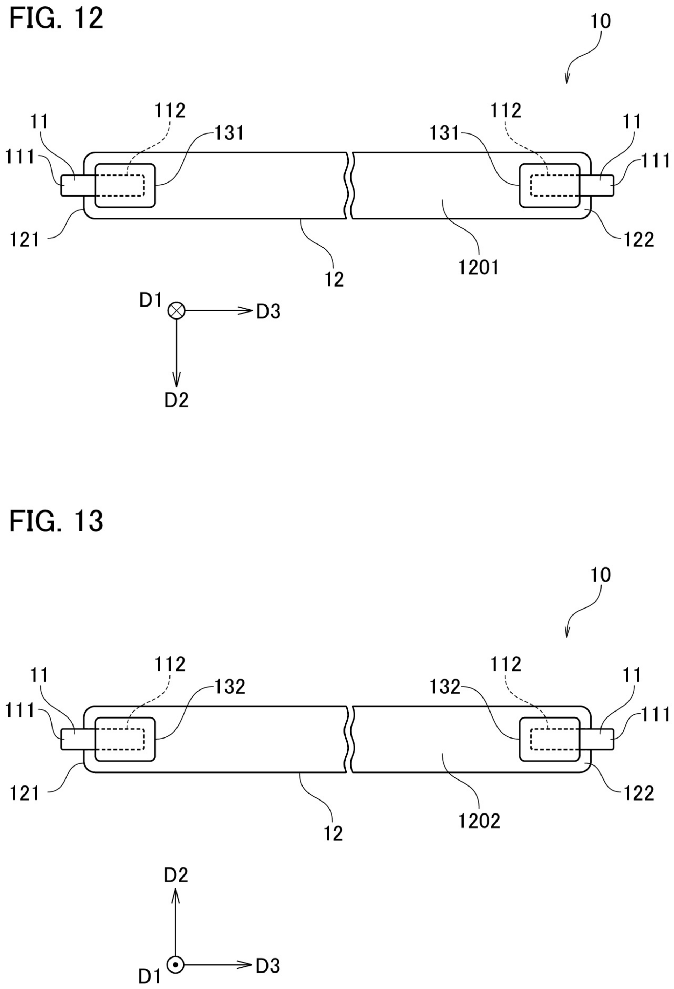

A description has been given of the probe 10 having a configuration in which the tip member 11 is arranged at the first end portion 121 of the main body 12 as an example. Meanwhile, the probe 10 as illustrated in FIGS. 12 and 13 may have a configuration in which the tip member 11 is arranged at each of the first end portion 121 and the second end portion 122 of the main body 12. FIG. 12 is a plan view of the first side surface 1201 of the main body 12 as viewed from the plane normal direction. FIG. 13 is a plan view of the second side surface 1202 of the main body 12 as viewed from the plane normal direction.

Even in the probe 10 illustrated in FIGS. 12 and 13, the reinforcing member 13 may be embedded in the side surface 120, or the reinforcing member 13 may be arranged on the surface of the side surface 120. In other words, at either the first end portion 121 or the second end portion 122, the reinforcing member 13 may be embedded in the side surface 120 or arranged on the surface of the side surface 120. Alternatively, the reinforcing member 13 may be arranged only on either the first side surface 1201 or the second side surface 1202.

### (Other Embodiments)

The embodiment of the present invention has been described above, but the statements and drawings forming part of this disclosure should not be understood as limiting the present invention. Various alternative embodiments, examples, and operating techniques will be apparent to those skilled in the art from this disclosure.

For example, although the case where the probe 10 has a rectangular cross-sectional shape has been described above, the probe 10 may have a cross section having other shapes. For example, the probe 10 may have a polygonal cross-sectional shape other than a rectangular shape. Regardless of what polygonal shape the cross-section of the probe 10 has, the reinforcing member 13 is arranged on the side surface of the main body 12 of the probe 10 so as to overlap with the tip member 11, thereby acquiring a reinforcing effect.

Further, although the case where the reinforcing member 13 is arranged on the column-shaped probe 10 has been described above, the reinforcing member 13 may be arranged at the end portion that connects to an inspection object or a land also for a probe other than the column-shaped probe, such as a cantilever structure.

It should be understood that the present invention includes various embodiments not described herein.

### REFERENCE SIGNS LIST

- 10: Probe
- 11: Tip member
- 12: Main body
- 13: Reinforcing member
- 20: Probe head
- 21: First guide plate
- 22: Second guide plate
- 23: Third guide plate
- 30: Substrate
- 31: Land
- 100: Electrical connection device
- 111: Contact portion
- 112: Base end portion
- 121: First end portion
- 122: Second end portion
- 131: First reinforcing member
- 132: Second reinforcing member
- 1201: First side surface
- 1202: Second side surface

## Claims

1. A probe used for inspecting electrical characteristics of an inspection object, comprising:
a tip member including a contact portion and a base end portion connected to the contact portion;
a main body in which the base end portion is embedded in an end portion so as to expose the contact portion; and
a reinforcing member arranged on a side surface of the main body so as to overlap with at least a part of the base end portion, and continuous from an embedded region in which the base end portion is embedded to a region around the embedded region.

2. The probe according to claim 1, wherein the reinforcing member is embedded in the side surface.

3. The probe according to claim 2, wherein the side surface of the main body around the embedded region and a surface of the reinforcing member are continuous without any step.

4. The probe according to claim 1, wherein the reinforcing member is arranged on a surface of the side surface.

5. The probe according to claim 1, wherein
a cross-section of the main body in a region in which the reinforcing member is arranged has a rectangular shape, and
the first reinforcing member is arranged on a first side surface of the main body.

6. The probe according to claim 5, wherein the reinforcing member is arranged on the first side surface and a second side surface facing the first side surface.

7. The probe according to claim 1, wherein the tip member and the reinforcing member are made of a same material.

8. The probe according to claim 1, wherein the tip member has a higher hardness than the main body.

9. An electrical connection device, comprising:
a probe head having a configuration in which a plurality of guide plates, each having a guide hole formed therein, are arranged apart from each other; and
a probe according to any one of claims 1 to 8, which is continuously inserted into the guide hole of each of the plurality of guide plates and held by the probe head.
